Europäisches Patentamt

European Patent Office

Office européen des brevets

(19)

(11) Veröffentlichungsnummer: **0 149 109**
**B1**

(12) EUROPÄISCHE PATENTSCHRIFT

(45) Veröffentlichungstag der Patentschrift:
30.08.89

(21) Anmeldenummer: 84114842.2

(22) Anmeldetag: 06.12.84

(51) Int. Cl.⁴: **H 03 K  3/03**

(54) Integrierte Halbleiterschaltung mit einem Ringoszillator.

(30) Priorität: 18.01.84 DE 3401610

(43) Veröffentlichungstag der Anmeldung:
24.07.85 Patentblatt 85/30

(45) Bekanntmachung des Hinweises auf die Patenterteilung: 30.08.89 Patentblatt 89/35

(84) Benannte Vertragsstaaten:
AT DE FR GB IT NL

(56) Entgegenhaltungen:
US—A— 3 441 804 .
US—A— 4 091 335

(73) Patentinhaber: **Siemens Aktiengesellschaft
Wittelsbacherplatz 2
D-8000 München 2 (DE)**

(72) Erfinder: **Bichler, Helmut
Bahnhofstrasse 103
D-8032 Gräfelfing (DE)**

## Beschreibung

Die vorliegende Erfindung befaßt sich mit einer integrierten halbleiterschaltung mit einem Ringoszillator, dessen Frequenz über den Betriebsstrom des Ringoszillators einstellbar ist, indem bezüglich ihrer Stromversorgung parallel geschaltete Inverterzellen des Ringoszillators gemeinsam mit einem Stromversorgungsanschluß über einen einstellbaren Widerstand mit dem an der Stromversorgung beteiligten Versorgungspotential verbunden sind. Dabei handelt es sich insbesondere um einen in I²L-Technik ausgeführten Ringoszillator.

Bei I²L-Ringoszillatoren und auch bei anderen in Bipolartechnik realisierten Ringoszillatoren ist es bekannt, daß die vom Oszillator gelieferte Frequenz von der Stärke des Betriebsstroms abhängt. Man kann also durch Einstellung des Gesamtbetriebsstroms des Oszillators und damit des Versorgungsstroms der einzelnen — einander gleichen — Zellen des Ringoszillators die Oszillatorfrequenz beeinflussen. Von dieser Tatsache wird z. B. bei den in der US-PS 4,079,338 beschriebenen integrierten Halbleiterschaltungen mit I²L-Ringoszillatoren Gebrauch gemacht.

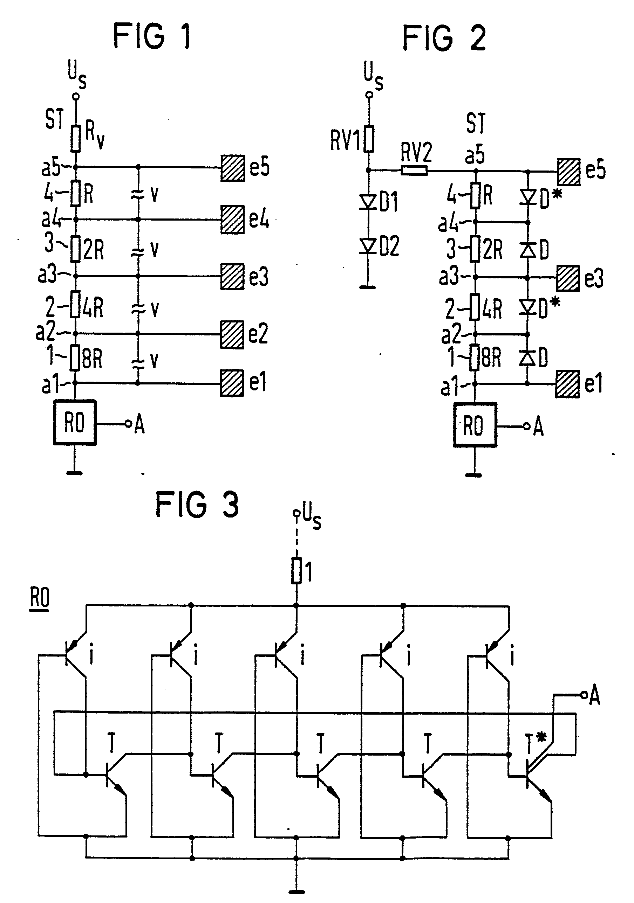

Wünschenswert ist nun, die Schaltung so auszugestalten, daß sie hinsichtlich der Frequenzgenauigkeit und Temperaturbeständigkeit der Frequenz sicher funktioniert. Beispielsweise kann man dies mittels einer Beschaltung durch Quarz- oder Keramikschwinger erreichen. Will man aber den Oszillater auf dem integrierten Baustein abgleichen, so ist bisher lediglich die Möglichkeit verfügbar, die dann anhand von Fig. 1 näher beschrieben wird. Diese Möglichkeit vermeidet zwar eine Außenbeschaltung. Sie verlangt jedoch einen verhältnismäßig großen Flächenbedarf der Abgleichschaltung in dem die integrierte Schaltung aufnehmenden Halbleiterplättchen.

Aufgabe der Erfindung ist es nun, eine solche Oszillatorschaltung hinsichtlich des Flächenbedarfs der Abgleichschaltung im Sinne einer Verminderung des Flächenbedarfs zu verbessern. Außerdem soll der Einfluß der Temperatur auf den Betrieb des Oszillators soweit reduziert sein, daß er vernachlässigt werden kann. Schließlich soll auch eine weitgehende Unabhängigkeit von der Versorgungsspannung gewährleistet werden.

Zur Lösung dieser Aufgabe wird gemäß der vorliegenden Erfindung eine der eingangs gegebenen Definition entsprechende integrierte Halbleiterschaltung derart ausgestaltet, daß der einstellbare Widerstand durch einen aus mehreren hintereinandergeschalteten Widerständen gebildeten Spannungsteiler gegeben ist, der sowohl mit seinem einen Endanschluß in übereinstimmender Weise mit dem einen Stromversorgungsanschluß der den Ringoszillator bildenden Inverterzellen und außerdem mit einer extern beaufschlagbaren Elektrode verbunden ist, während — numeriert in Richtung des wachsenden Abstands von diesem Endanschluß — jeder ungeradzahlig numerierte weitere Anschluß des Spannungsteilers ebenfalls jeweils an je eine weitere extern beaufschlagbare Elektrode der integrierten Schaltung gelegt und außerdem über je eine Diode mit seinen beiden — geradzahlig numerierten — Nachbaranschlüssen verbunden ist und daß hierzu die Anode dieser Verbindungsdioden an dem ungeradzahlig numerierten Anschluß und die Kathode an je einem der beiden benachbarten geradzahlig numerierten Anschlüsse des Spannungsteilers liegt.

Die Erfahrung bei Durchführung der Erfindung hat gezeigt, daß man bei Verwendung eines I²L-Ringoszillators und der dann anzuwendenden für I²L-Schaltungen üblichen Werte für die Versorgungsspannung (also etwa 2,5 V) im allgemeinen mit drei zusätzlichen Elektroden und vier in der genannten Weise geschalteten Dioden auskommt, wie dies aus Fig. 2 ersichtlich ist. Hingegen benötigt man bei der genannten älteren Möglichkeit zwar keine Dioden, jedoch werden 5 extern zu beaufschlagende Elektroden und außerdem anstelle jeder der genannten Dioden eine auftrennbare leitende Verbindung benötigt.

Insbesondere ist bei der Erfindung im Interesse der Unterdrückung des Temperatureinflusses auf die Oszillatorfrequenz vorgesehen, daß der das Versorgungspotential $U_s$ führende Anschluß der integrierten Schaltung in der aus Fig. 2 ersichtlichen Weise mit dem Spannungsteiler verbunden und außerdem an das Fußpunktspotential der Schaltung angeschlossen wird.

Schließlich empfiehlt es sich, daß die den Spannungsteiler bildenden Widerstände hinsichtlich ihres Widerstandswerts unterschiedlich bemessen sind, was offensichtlich auch für die in Fig. 1 dargestellte Möglichkeit gilt. Am günstigsten ist hierbei, wenn — höchstens mit Ausnahme des den letzten der mit einer der genannten Elektroden verbundenen Anschlußpunkt mit dem Versorgungspotential verbindenden Endwiderstands — die zwischen den Anschlußpunkten des Spannungsteilers liegenden Widerstände binär gewichtet sind. Zum Beispiel hat dann der an den Stromeingängen des Ringoszillators liegende Widerstand den höchsten Widerstandswert, während der Widerstandswert mit wachsender Entfernung vom Ringoszillator bis auf den binären Grundwert abnimmt, wie dies in Fig. 1 als auch in Fig. 2 der Fall ist.

Bisher stand — abgesehen von der gennanten Beschaltung mit einem Quarz- oder Keramikschwinger — lediglich die in Fig. 1 gezeïgte Möglichkeit zur Verfügung. Sie teilt mit der Erfindung die Verwendung eines Spannungsteilers als einstellbaren Widerstand, der die Verbindung zwischen den Stromanschlüssen der Inverterzellen des Ringoszillators RO und der Klemme für das Versorgungspotential $U_s$ bildet. Sowohl der am Ringoszillator RO liegende Endanschluß a1 als auch jeder der Zwischenanschlüsse a2, a3, a4 und a5 des aus den binär gewichteten Widerständen 1, 2, 3, 4 und dem an der Klemme für das

Versorgungspotential $U_s$ liegenden Endwiderstand bestehenden Spannungsteilers ST sind über je eine Leitung mit je einer extern beaufschlagbaren Elektrode e1 bzw. e2, e3, e4 und e5 verbunden. Außerdem liegt zwischen je zwei benachbarten dieser Elektroden e1, e2, e3, e4 und e5 je eine auftrennbare Verbindung v.

Man erkennt unmittelbar, daß bei intaktem Zustand aller dieser Querverbindungen v der Oszillatorstrom seinen höchsten Wert hat, da vom Spannungsteiler ST lediglich der an $U_s$ liegende Endwiderstand infolge des Kurzschlusses aller weiteren Widerstände an der Begrenzung des Oszillatorstroms wirksam beteiligt ist. Wird nun irgend eine der auftrennbaren Verbindungen v zerstört, so wird der von dieser Verbindung v überbrückte Widerstand des Spannungsteilers ST in die Stromversorgung des Oszillators RO miteingeschaltet und der Oszillatorstrom je nach dem Widerstandswert dieses Widerstands reduziert und damit die Oszillatorfrequenz in entsprechender Weise vermindert. Zur Auftrennung der die einzelnen Widerstände 1 bis 4 des Spannungsteilers ST überbrückenden und in üblicher Weise als Schmelzsicherung (Fusible link) ausgestalteten Querverbindungen vi dienen jeweils die beiden dem betreffenden Widerstand des Spannungsteilers und damit der diesen überbrückenden Querverbindung v zugeordneten beiden Elektroden, also beim Widerstand die Elektrode eγ und eγ+₁. Der Zweck der für die Widerstände 1 - 4 vorgesehenen Wichtung ist ohne weiteres verständlich.

Bei der von der Erfindung vorgeschlagenen und in Fig. 2 dargestellten Ausgestaltung sind ebenfalls vier den Spannungsteiler ST zusammen mit die Verbindung zum Versorgungspotential $U_s$ bildende Widerstände 1 - 4 vorgesehen. Es werden jedoch nur drei extern zu beaufschlagende Elektroden, nämlich die Elektroden e1, e3 und e5 benötigt, die den entsprechend bezeichneten Elektroden in Fig. 1 entsprechen. Demgemäß und gemäß der Definition der Erfindung ist die Elektrode e1 an dem mit dem Ringoszillator RO unmittelbar verbundenen Endanschluß a1 des Spannungsteilers ST und damit mit dem Endwiderstand 1 angelegt. Die Elektrode e3 ist mit dem zwischen den Widerständen 2 und 3 des Spannungsteilers liegenden Zwischenanschluß a3 und die Elektrode e5 mit dem zwischen dem Widerstand 4 und dem zum Versorgungspotential $U_s$ führenden Endwiderstand liegenden Zwischenanschluß a5 leitend verbunden. Außerdem ist jeder der den Spannungsteiler zwischen den extern beaufschlagbaren Elektroden e1 bzw. e3 bzw. e5 liegende Widerstand, also der Widerstand 1, der Widerstand 2, der Widerstand 3 und der Widerstand 4 jeweils durch eine Diode überbrückt. Entsprechend der Definition der Erfindung ist dabei jeder ungeradzahlig numerierte Widerstand (mit Ausnahme des an $U_s$ liegenden Endwiderstands bzw. bei der in Fig. 2 gezeigten Ausgestaltung des Endwiderstandspaars RV1 und RV2) durch eine Diode D überbrückt, deren Anode am jeweils niedriger numerierten Anschluß und deren Kathode am jeweils höher numerierten Anschluß des betreffenden Widerstands (also des Widerstands 1, des Widerstands 3) liegt, während ihre Kathode an dem jeweils höher numerierten Anschluß des Widerstands des Spannungsteilers ST liegt. Jeder geradzahlig numerierte Widerstand (also der Widerstand 2, der Widerstand 4) ist jeweils durch eine Diode D* überbrückt, wobei die Anode dieser Überbrückungsdiode D* am jeweils höher numerierten Anschluß und die Kathode am jeweils niedriger numerierten Anschluß des jeweils überbrückten Widerstands liegt. Im Normalfall sind die Überbrückungsdioden hinsichtlich ihrer Eigenschaften völlig übereinstimmend, so daß auch zwischen den Dioden D und den Dioden D* in dieser Beziehung kein Unterschied besteht.

Wie bei der Ausgestaltung gemäß Fig. 1 hat bei der der Erfindung entsprechenden Ausgestaltung gemäß Fig. 2 der am Ringoszillator RO liegende Teilwiderstand 1 des Spannungsteilers den höchsten Widerstandswert von 8R, der folgende Teilwiderstand den Widerstandswert von 4R der dritte Teilwiderstand 3 den Wert von 2R und der vierte Teilwiderstand 4 den Grundwert R. An sich könnten auch die Widerstandswerte der Teilwiderstände in anderer Weise gestaffelt, bzw. bei einer Ausgestaltung mit binärer Wichtung in anderer Reihenfolge als in Fig. 2 gezeigt, angeordnet sein. Der Sinn der Staffelung der Widerstandswerte liegt darin, daß der Oszillatorstrom und damit die Oszillatorfrequenz auf möglichst viele Werte eingestellt werden kann. Im Prinžip könnte auch der am Versorgungspotential $U_s$ liegende Endwiderstand, der dem Widerstand RV bei der Schaltung gemäß Fig. 1 entspricht, an der Wichtung beteiligt sein.

Bei der bevorzugten Ausgestaltung der Erfindung gemäß Fig. 2 ist der dem Vorwiderstand RV in Fig. 1 entsprechende Vorwiderstand durch die Serienschaltung zweier Widerstände RV1 (liegt an der Klemme für $U_s$) und RV2 (liegt am letzten ungeradzahlig numerierten und mit einer extern beaufschlagbaren Elektrode verbundenen Teileranschluß a5 des Spannungsteilers ST) gegeben. Der zwischen den beiden Widerständen RV1 und RV2 liegende Verbindungspunkt ist seinerseits über die Kette zweier weiterer Dioden D1 und D2 mit dem Bezugspotential (Fußpunktpotential der Schaltung verbunden, wobei die Anode der ersten Diode D1 an dem besagten Verbindungspunkt und die Kathode der anderen Dioden D2 and der Klemme für das Bezugspotential liegt.

In Fig. 3 ist das Schaltbild des in üblicher Weise in I²L-Technik realisierten Ringoszillators RO dargestellt. Jede Inverterzelle des Ringoszillators RO besteht aus einem vertikalen (und im Aufwärtsbetrieb arbeitenden) npn-Transistor T und einem als Injektor i geschalteten lateralen pnp-Transistor. Da bekanntlich die Basis des pnp-Transistors i mit dem Emitter des vertikalen npn-Transistors eine erste gemeinsame Zone — und zwar vom n-Typ — und der Kollektor des Transistors i mit der Basis von T eine zweite gemeinsame Zone — und zwar vom p-Typ bilden und die Basis des Injektortransistors i der betreffenden Zelle an dem Bezugspotential und sein Emitter am Endanschluß a1 des Spannungteilers ST liegt, ist die in Fig. 3 ersichtliche Anschaltung der einzelnen Injektortransistoren i ohne weiteres verständlich. Der eigentliche Inverter wird durch den jeweiligen npn-Transistor T bzw. im Falle der letzten Zelle durch den den Transistor T dort ersetzenden Transistor T* gegeben, wobei die Basis des npn-Transistors T bzw. T* den Signaleingang und der Kollektor den Signalausgang bildet. Um eine weitgehende Unabhängigkeit der vom Signalausgang des letzten Inverters zum Signaleingang des ersten Inverters der den Ringoszillator RO bildenden Inverterkette führenden Rückkopplung von dem durch den Ringoszillatorausgang A zu beaufschlagenden Teil der integrierten Schaltung zu erreichen, empfiehlt es sich, den npn-Transistor der letzten Stufe als Zwei-Kollektortransistor auszugestalten, wobei der eine kollektor im Rückkopllungszweig liegt und der andere den Signalausgang A des Oszillators RO bildet. Hinsichtlich der Abmessung des Emitters, der Basis und des im Rückkopplungszweig liegenden sowie des Ausgangskollektors ist zwischen dem Transistor T* der Ausgangszelle und dem Transistor T der übrigen Zellen des Oszillators weitgehende Übereinstimmung angestrebt und bekanntlich auch erreichbar. Die Anzahl der den Ringoszillator bildenden Inverterzellen ist im Interesse der Sicherstellung der Ringoszillatorwirkung im allgemeinen ungerade und größer als 1. Bevorzugt sind fünf Inverterzellen.

Die der Erfindung entsprechende und in Fig. 2 dargestellte Abgleichschaltung für den Ringoszillator RO funktioniert so, daß bei intaktem Zustand aller vorgesehenen Dioden D und D* die Verbindung zwischen dem Versorgungspotential $U_s$ (= 2,5 V) und dem Stromeingang des Ringoszillators RO nur unter Vermittlung des gesamten Spannungsteilers ST erfolgt. Über die jeweils benachbarten Elektroden e1 und e3 bzw. e3 und e5 kann bei entsprechender Spannungsbeaufschlagung entweder die zugehörige Überbrückungsdiode D oder die Überbrückungsdiode D* zum permanenten Durchbruch gebracht werden. Es wird also über die Abgleichpads e1, e3 und e5 ein Strom durch die Dioden D bzw. D* eingeprägt, der so bemessen wird, daß die jeweils als Zenerdiode wirkende Diodenstruktur zerstört wird und dann einen Kurzschluß für den jeweils zugeordneten Spannungsteilerwiderstand darstellt. Auf diese Weise lassen sich beliebige Widerstände der durch den Spannungsteiler ST gegebenen Widerstandskaskade (mit Ausnahme der Endwiderstände RV1 und RV2) von der Stromversorgung des Ringoszillators RO abschalten.

Die durch die beiden Vorwiderstände RV1 und RV2 in Verbindung mit den beiden Dioden D1 und D2 sowie einer Versorgungsspannung $U_s$ von 2,5 V bedingte Temperaturkompensation hält die Frequenzdrift über die Temperatur auf einem vernachlässigbaren Minimum. Die Frequenz am Ausgang A des Ringoszillators RO (vor allem bei einer Realisierung in I²L-Schaltung) hat einen Temperaturgang, welcher, wie Praxis und Rechnung zeigen, in Verbindung mit den durch den (z. B. als Taktgenerator dienenden) Ringoszillator RO zu beaufschlagenden weiteren Elementen in der integrierten Schaltung bei Anwendung der in Fig. 2 gezeigten Schaltungsweise kompensiert wird.

Infolge des Querstroms über die beiden Dioden D1 und D2 veringert sich außerdem die Abhängigkeit der Oszillatorfrequenz von der Versorgungsspannung $U_s$ (bevorzugt 2,5 V bei der aus Fig. 2 und 3 ersichtlichen Realisierung). Wenn sich der Querstrom durch die beiden Dioden D1 und D2 um den Faktor K verändert, schwankt der Strom im Ringoszillator RO und damit die von diesem gelieferte Frequenz um den Faktor log nat k.

Die Frequenz des Ringoszillators RO ist nur dann ausreichend temperaturkompensiert, wenn die Versorgungsspannung $U_s$, die Vorwiderstände RV1 und RV2 und die Anzahl der Dioden aufeinander abgestimmt sind. Ist $U_s$ merklich größer als 2,5 V, dann muß der Wert für den an $U_s$ liegenden Widerstand und die Anzahl der Dioden (die den Dioden D1 und D2 entsprechen) entsprechend vergrößert werden. Dies gilt insbesondere, wenn der Ringoszillator RO in anderer Technik, z. B. in TTL-Technik oder in ECL-Technik realisiert werden soll.

Hinsichtlich der in Fig. 2 dargestellten Ausgestaltung der Erfindung ist noch zu bemerken, daß aus der dort angewendete Wichtung der Widerstandswerte in dem zuschaltbaren Teil der Widerstandskette 1 - 4 der Vorteil resultiert, daß die gewünschte Genauigkeit für den Versorgungsstrom des Ringoszillators mit möglichst geringem Aufwand erreichbar ist.

## Patentansprüche

1. Integrierte Halbleiterschaltung mit einem Ringoszillator (RO), dessen Frequenz über den Betriebsstrom des Ringoszillators einstellbar ist, indem bezüglich ihrer Stromversorgung parallelgeschaltete Inverterzellen des Ringoszillators gemeinsam mit einem Stromversorgungsanschluß über einen einstellbaren Widerstand mit dem an der Stromversorgung beteiligten Versorgungspotential ($U_s$) verbunden sind, dadurch gekennzeichnet, daß der einstellbare Widerstand durch einen aus mehreren hintereinander geschalteten Widerständen (1, 2, 3, 4, RV) gebildeten Spannungsteiler (ST) gegeben ist, der sowohl mit seinem einen Endanschluß (a1) in übereinstimmender Weise mit dem einen Stromversorgungsanschluß der den Ringoszillator (RO) bildenden Inverterzellen (T,i, bzw. T*,i) und außerdem mit einer extern beaufschlagbaren Elektrode (e1) verbunden ist, währendgezählt in Richtung des wachsenden Abstands von diesem Endanschluß (a1)-jeder ungeradzahlig numerierte weitere Anschluß ($a_\gamma$) des Spannungsteilers (ST) ebenfalls jeweils an je eine weitere extern beaufschlagbare Elektrode ($e_\gamma$) der integrierten Schaltung gelegt und außerdem über je eine Diode (D bzw. D*) mit seinen beiden Nachbaranschlüssen (a$_{\gamma-1}$ bzw. a$_{\gamma+1}$) verbunden ist, und daß schließlich hierzu die Anode dieser Verbindungsdioden (D bzw. D*) an dem betreffenden ungeradzahlig numerierten Anschluß (a$_\gamma$) und ihre Kathode an je einem der beiden beiden benachbarten und geradzahlig numerierten Anschlüsse — ggf. mit Ausnahme des letzten geradzahlig numerierten Anschlusses-vor dem Versorgungspotential (U$_s$) — liegt.

2. Integrierte Halbleiterschaltung nach Anspruch 1, dadurch gekennzeichnet, daß der vom Ringoszillator (RO) aus gesehen letzte mit einer extern beaufschlagbaren, aber nicht an der Versorgungsspannung (U$_s$) liegenden Elektrode (e5) verbundene Anschluß des Spannungsteilers (ST) über einen durch zwei hintereinander geschaltete Festwiderstände (RV1, RV2) gebildeten Endwiderstand an die das Versorgungspotential (U$_s$) liefernde Versorgungsklemme gelegt ist, während der zwischen diesen beiden Festwiderständen (RV1, RV2) liegende Teilerpunkt durch eine Diodenkette (D1, D2) mit der Klemme für das Bezugspotential (Masse) verbunden ist und dabei die Anoden der die Diodenkette bildenden Dioden (D1, D2) dem Teilerpunkt zugewandt sind.

3. Integrierte Halbleiterschaltung nach Anspruch 1 oder 2, dadurch gekennzeichnet, daß der Ringoszillator und insbesondere auch die übrige integrierte Schaltung in I²L-Technik ausgestaltet ist.

4. Integrierte Halbleiterschaltung nach einem der Ansprüche 1 bis 3, dadurch gekennzeichnet, daß die den Spannungsteiler (ST) zwischen dem Ringoszillator (RO) und dem letzten der extern beaufschlagbaren, jedoch nicht am Versorgungspotential (U$_s$) liegenden Elektrode (e5) der integrierten Schaltung vorgesehenen Widerstände (1-4) des Spannungsteilers binär bezüglich ihrer Widerstandswerte gewichtet sind.

5. Integrierte Halbleiterschaltung nach Ansprunch 3, dadurch gekennzeichnet, daß die Versorgungsspannung 2,5 V beträgt.

## Claims

1. Integrated semiconductor circuit with a ring oscillator (RO), the frequency of which is adjustable via the operating current of the ring oscillator in that inverter cells of the ring oscillator, which are connected in parallel with reference to their power supply, are connected, in common with a power supply terminal, via an adjustable resistor to the supply potential (U$_s$) participating in the power supply, characterized in that the adjustable resistor is provided by a voltage divider (ST), which is formed from several resistors (1, 2, 3, 4, RV) connected one after another, and is both connected conformably with its one final terminal (a1) to the one power supply terminal of the inverter cells (T,i, or T*,i) forming the ring oscillator (RO), and moreover to an externally triggerable electrode (e1), while — counting in the direction of increasing distance from this final terminal (a1) — each odd-numbered further terminal (a$_\gamma$) of the voltage divider (ST) is likewise, in each case, connected respectively to a further externally triggerable electrode (e$_\gamma$) of the integrated circuit, and is moreover connected via a diode (D or D*) in each case to its two adjacent terminals (a$_{\gamma-1}$ or a$_{\gamma+1}$), and in that, finally, to this end upstream of the supply potential (U$_s$) the anode of these connecting diodes (D or D*) is connected to the odd-numbered terminal (a$_\gamma$) concerned and their cathode is connected in each case to one of the two adjacent and even-numbered terminals — if necessary with the exception of the last even-numbered terminal.

2. Integrated semiconductor circuit according to Claim 1, characterized in that the terminal of the voltage divider (ST), which is last when viewed from the ring oscillator (RO) and connected to an externally triggerable electrode (e5), which is not however connected to the supply voltage (U$_s$), is connected via a terminal resistor, which is formed from two fixed resistors (RV1, RV2) connected one after the other to the supply terminal delivering the supply potential (U$_s$), while the divider point lying between these two fixed resistors (RV1, RV2) is connected via a diode chain (D1, D2) to the terminal for the reference potential (earth), and in this arrangement the anodes of the diodes (D1, D2) forming the diode chain are turned towards the divider point.

3. Integrated semiconductor circuit according to Claim 1 or 2, characterized in that the ring oscillator and especially also the remaining integrated circuit is constructed using I²L technology.

4. Integrated semiconductor circuit according to one of Claims 1 to 3, characterized in that the resistors (1-4) of the voltage divider, which are provided for the voltage divider (ST) between the ring oscillator (RO) and the last of the electrodes (e5) of the integrated circuit which are externally triggerable but not connected to the supply potential (U$_s$), are weighted in a binary fashion with reference to their resistance values.

5. Integrated semiconductor circuit according to Claim 3, characterized in that the supply voltage amounts to 2.5 V.

## Revendications

1. Circuit intégré à semiconducteurs comportant un oscillateur annulaire (RO), dont la fréquence est réglée au moyen du courant de service de l'oscillateur annulaire, grâce au fait que des cellules formant inverseurs de l'oscillateur annulaire, branchées en parallèle du point de vue de leur alimentation en courant, sont reliées, ainsi que leurs bornes d'alimentation en courant, par l'intermédiaire d'une résistance réglable, au potentiel d'alimentation (U$_s$) intervenant pour l'alimentation en courant, caractérisé par le fait que la résistance réglable est formée par un diviseur de tension (ST), qui est formé par plusieurs résistances (1, 2, 3, 4, RV) branchés en série et qui est relié d'une manière coïncidante, par l'une de ses bornes d'extrémité (a1), à une borne d'alimentation en courant des cellules formant inverseurs (T,i ou T*,i) constituant l'oscillateur annulaire (RO) et en outre, à une électrode (e1) pouvant être chargée de l'extérieur, tandis que — le comptage étant réalisé à partir de cette borne d'extrémité (a1) — chaque borne supplémentaire ($a_\gamma$), d'ordre impair, du diviseur de tension (ST) est également raccordée respectivement à une autre électrode (e), pouvant être chargée de l'extérieur, du circuit intégré et en outre, par l'intermédiaire d'une diode respective (D ou D*), aux deux bornes voisines ($a_{\gamma-1}$ et $a_{\gamma+1}$), qui en sont voisines, et qu'enfin l'anode de ces diodes de liaison (D ou D*) est raccordée à la borne d'ordre impair considérée (e) et que sa cathode est raccordée respectivement à l'une des deux bornes voisnes d'ordre pairs — éventuellement à l'exception de la dernière borne d'ordre pair — avant le potentiel d'alimentation ($U_s$).

2. Circuit intégré à semiconducteurs suivant la revendication 1, caractérisé par le fait que la borne du diviseur de tension (ST), qui est la dernière à partir de l'oscillateur annulaire (RO), est reliée à une électrode (e5) pouvant être chargée de l'extérieur, mais non raccordée à la tension d'alimentation ($U_s$), et est raccordée, par l'intermédiaire d'une résistance d'extrémité formée par deux résistances fixes branchées en série, à la borne d'alimentation délivrant le potentiel d'alimentation ($U_s$), tandis que le point de division situé entre ces deux résistances fixes (RV1, RV2) est relié par une chaîne de diodes (D1, D2) à la borne fournissant le potentiel de référence (masse) et que les anodes des diodes (D1, D2) formant la chaîne de diodes sont tournées vers le point de division.

3. Circuit à semiconducteurs intégré suivant la revendication 1 ou 2, caractérisé par le fait que l'oscillateur annulaire et notamment également le reste du circuit intégré réalisés selon la technique I²L.

4. Circuit intégré à semiconducteurs suivant l'une des revendications 1 à 3, caractérisé par le fait que les résistances (1-4) du diviseur de tension (ST) qui sont prévues pour ce dernier, entre l'oscillateur annulaire (RO) et la dernière électrode (e5) du circuit intégré, chargée de l'extérieur, mais non portée au potentiel d'alimentation ($U_s$), ont des valeurs qui sont pondérées en binaire.

5. Circuit intégré à semiconducteurs suivant la revendication 3, caractérisé par le fait que la tension d'alimentation est égale à 2,5 V.

# FIG 1

# FIG 2

# FIG 3